# EUROPEAN PATENT APPLICATION

(11) **EP 4 502 011 A1**
(43) Date of publication of application: **05.02.2025**
(21) Application number: 23774445.3
(22) Date of filing: 03.03.2023
(51) Int. Cl.: C08G 75/02, C08L 81/02, C09J 4/02, C09J 11/00, C09J 11/06, C09J 181/02, H01L 23/10

(54) **RESIN COMPOSITION, ADHESIVE AGENT, ENCAPSULANT, CURED PRODUCT, SEMICONDUCTOR DEVICE, AND ELECTRONIC COMPONENT**

(30) Priority: 24.03.2022 JP 2022048208
(71) Applicant: Namics Corporation, Niigata-shi, Niigata 950-3131 (JP)
(72) Inventor: MITSUNUSHI Koki, Niigata-shi, Niigata 950-3131 (JP); OTSUBO Kodai, Niigata-shi, Niigata 950-3131 (JP)
(74) Representative: Hoffmann Eitle
(86) International application number: PCT/JP2023/008003
(87) International publication number: WO 2023/181846

(57) **Abstract**

The object of the present invention is to provide at least thermo-curable resin compositions and adhesives capable of reducing the bleeding phenomenon.

The present invention provides a resin composition comprising:
(A) a (meth)acrylate compound,
(B) a polythiol compound,
(C) a curing catalyst, and
(D) a surfactant having two or more hydrophilic groups selected from the group consisting of a hydroxyl group and a carbonyl group in the molecule.

## Description

### Field of the Invention

The present invention relates to resin compositions, adhesives or sealants containing the same, cured products thereof, and semiconductor devices and electronic components containing the cured products.

### Background Art

Photo- and thermo-curable resin compositions are known that can be temporarily fixed by photo irradiation and furthermore, can be main cured by heating. More specifically, adhesives that are cured by a two-step process that includes curing by ultraviolet (UV) irradiation (UV curing) and subsequent curing by heating (thermal curing) are used in many fields (see, for example, Patent Documents 1 and 2). This type of adhesive is particularly well used in image sensor module applications.

Patent Document 3 discloses a resin composition containing (1) a compound having a (meth)acryloyl group, (2) a polyene compound having two or more vinyl or allyl groups in one molecule, (3) a polythiol compound having two or more thiol groups in one molecule, (4) a photo-radical generator, (5) a thermal radical generator and (6) a thermal anionic polymerisation initiator, as a photo- and thermo-curable resin composition having both excellent photo-curing properties and excellent thermo-curing properties, wherein when light irradiation is carried out under conditions that produce light-unirradiated portions, subsequent heating can completely cure the entire composition including the light-unirradiated portions to produce a cured product with high adhesive strength, and which also has good storage stability.

### PRIOR ART REFERENCE

### Patent Document

Patent Document 1: Japanese Unexamined Patent Publication No. 2009-51954
Patent Document 2: WO 2005/052021
Patent Document 3: Japanese Unexamined Patent Publication No. 2017-101112

### Summary of the Invention

### Problems to be Solved by the Invention

Bleeding has been an issue in the assembly process of semiconductor modules. Bleeding is a phenomenon in which unreacted components seep out of an applied adhesive or cured product over time when an adhesive containing a curable resin composition is used to fix or bond parts, and the seeping components themselves are sometimes referred to as 'bleed'. The bleed may contact the metal wiring section on the substrate, which may cause electrical defects and reduce the reliability and bonding properties of the semiconductor module.

In particular, when adhesives containing photo- and thermo-curable resin compositions are used in the assembly process of semiconductor modules (e.g. image sensor modules or camera modules), UV irradiation curing involves UV irradiation from the outside of the semiconductor module, so the inside of the semiconductor module is not exposed to UV light and uncured portions of the adhesive can exist. Inner bleed generated from uncured parts of that adhesive tends to develop and increase the bleed length when the adhesive is left at room temperature after UV irradiation and during subsequent thermal curing. In some cases, depending on where the adhesive is applied, the adhesive may be cured by thermal curing only, as UV irradiation is not possible due to shadowing of the component. In this case, too, there is a problem that bleeding phenomenon is likely to occur from the applied adhesive portion when left at room temperature or when thermal curing.

In recent years, electronic components such as semiconductor chips have been required to be increasingly smaller or more integrated, and the distances to wiring sections located around electronic components have become shorter. In semiconductor modules with such miniaturised or highly integrated electronic components, the risk of contact between the bleed and the wiring section increases due to the bleeding phenomenon.

It is therefore an object of the present invention to provide at least thermo-curable resin compositions and adhesives capable of reducing the bleeding phenomenon.

### Means for Solving the Problems

Specific measures to solve the aforementioned problems are as follows.

The first aspect of the invention includes the following resin compositions.
[1] A resin composition comprising:
   (A) a (meth)acrylate compound,
   (B) a polythiol compound,
   (C) a curing catalyst, and
   (D) a surfactant having two or more hydrophilic groups selected from the group consisting of a hydroxyl group and a carbonyl group in the molecule.
[2] The resin composition as described in [1] above, wherein the (D) surfactant is a surfactant having two or more hydroxyl groups in the molecule.
[3] The resin composition as described in [1] or [2] above, wherein the (D) surfactant is (D1) a surfactant with a hydrophilic portion containing a cyclic structure and/or (D2) a gemini-type surfactant.
[4] The resin composition as described in any one of [1] to [3] above, further comprising (G) a photo-radical initiator.
   The second aspect of the invention includes the following adhesives or sealants.
[5] An adhesive or a sealant comprising the resin composition as described in any one of [1] to [4] above.
[6] The adhesive or sealant as described in [5] above, for use in the fixation, adhesion or protection of components of an image sensor or a camera module.
   The third aspect of the invention includes the following cured products.
[7] A cured product in which the resin composition as described in any one of [1] to [4] above or the adhesive or sealant as described in [5] or [6] above has been cured.
   The fourth aspect of the invention includes the following semiconductor devices or electronic components.
[8] A semiconductor device or an electronic component comprising the cured product as described in [7] above.
[9] The semiconductor device or the electronic component as described in [8] above, which is an image sensor or a camera module.

### Effects of the Invention

According to the first aspect of the invention, it is possible to obtain at least thermo-curable resin composition capable of reducing the bleeding phenomenon. According to the second aspect of the invention, it is possible to obtain at least thermo-curable adhesive or a sealant capable of reducing the bleeding phenomenon. According to the third aspect of the invention, it is possible to obtain a cured product with reduced bleeding phenomenon. According to the fourth aspect of the invention, it is possible to obtain a semiconductor device or an electronic component containing a cured product with reduced bleeding phenomenon, and with excellent reliability and bonding properties.

### Mode for carrying out the Invention

### [Resin composition]

The resin composition which is the first aspect of the invention contains:
(A) a (meth)acrylate compound,
(B) a polythiol compound,
(C) a curing catalyst, and
(D) a surfactant having two or more hydrophilic groups selected from the group consisting of a hydroxyl group and a carbonyl group in the molecule.

According to the present aspect, it is possible to obtain at least thermo-curable resin composition capable of reducing the bleeding phenomenon.

### (A) (Meth)acrylate compound

The resin composition of the present aspect contains (A) a (meth)acrylate compound (hereinafter also referred to as "Component (A)"). (A) (Meth)acrylate compound can impart transparency and moderate hardness to the resin composition after curing. The (meth)acrylate compound that is Component (A) is not limited as long as it contains a compound with two or more (meth)acryloyl groups. In consideration of ensuring heat resistance, compounds with two or more (meth)acryloyl groups are preferred, compounds with 2 to 6 (meth)acryloyl groups are more preferred, and compounds with 2 (meth)acryloyl groups are even more preferred. In addition to compounds with two (meth)acryloyl groups, compounds with one (meth)acryloyl group can be used to adjust viscosity and physical properties of cured products (adhesive strength, flexibility, etc.).

Examples of (A) (meth)acrylate compound include, but are not limited to, diacrylate and/or dimethacrylate of tris(2-hydroxyethyl)isocyanurate; triacrylate and/or trimethacrylate of tris(2-hydroxyethyl)isocyanurate; trimethylolpropane triacrylate and/or trimethacrylate, or oligomers thereof; pentaerythritol triacrylate and/or trimethacrylate, or oligomers thereof; polyacrylate and/or polymethacrylate of dipentaerythritol; tris(acryloxyethyl)isocyanurate; caprolactone-modified tris(acryloxyethyl)isocyanurate; caprolactone-modified tris(methacryloxyethyl)isocyanurate; polyacrylate and/or polymethacrylate of alkyl-modified dipentaerythritol; polyacrylate and/or polymethacrylate of caprolactone-modified dipentaerythritol; ethoxylated bisphenol A diacrylate and/or ethoxylated bisphenol A dimethacrylate; dihydrocyclopentadiethyl acrylate and/or dihydrocyclopentadiethyl methacrylate, and polyester acrylate and/or polyester methacrylate, dimethylol-tricyclodecanediacrylate, poly(meth)acrylate of ditrimethylolpropane, polyurethanes having two or more (meth)acryloyl groups per molecule, polyesters having two or more (meth)acryloyl groups per molecule, phenoxyethyl acrylate, isobornyl acrylate, phenoxydiethylene glycol (meth)acrylate, 4-tert-butylcyclohexyl (meth)acrylate, half epoxy acrylate (partially esterified epoxy resin), and the like. From the viewpoint of reactivity, it is preferred that Component (A) is substantially free of methacrylate compounds and consists of acrylate compounds.

Any one of the above mentioned (meth)acrylate compounds may be used alone, or two or more may be used in combination for (A) (meth)acrylate compound.

It is preferred that Component (A) has a viscosity of 0.01 to 100 Pa-s from the viewpoint of preparation and dispensability of the resin composition. As used herein, viscosity refers to the value measured at a measurement temperature of 25°C using a viscometer appropriate for the viscosity range.

Examples of commercially available products of Component (A) include, but are not limited to, polyester acrylate from DAICEL-ALLNEX LTD. (trade name: EBECRYL810), ditrimethylolpropane tetraacrylate from DAICEL-ALLNEX LTD. (trade name: EBECRYL140), polyester acrylate from Toagosei Co., Ltd. (trade name: M7100), dimethylol tricyclodecane diacrylate from KYOEISHA CHEMICAL Co., LTD (trade name: Light Acrylate DCP-A), neopentylglycol modified trimethylolpropanediacrylate from Nippon Kayaku Co., Ltd. (trade name: Kayarad R-604), and the like. Any one of them may be used alone, or two or more may be used in combination for Components (A).

From the viewpoint of adhesive strength of the resin composition, the content of Component (A) is preferably 10 to 70% by mass, and more preferably 20 to 60% by mass relative to the total mass of the resin composition.

### (B) Polythiol compound

The resin composition of the present aspect contains (B) a polythiol compound (hereinafter also referred to as "Component (B)"). The (B) polythiol compound imparts high photo-curability to the resin composition. Component (B) is not limited as long as it has two or more functionalities, i.e., two or more thiol groups. It is preferable that Component (B) contains trifunctional or more compounds, and it is more preferable that it contains trifunctional and/or tetrafunctional thiol compounds. The trifunctional and tetrafunctional thiol compounds are thiol compounds with three and four thiol groups, respectively.

Examples of the polythiol compound include, but are not limited to, pentaerythritol tetrakis(3-mercaptopropionate), trimethylolpropane tris(3-mercaptopropionate), dipentaerythritol hexakis(3-mercaptopropionate), pentaerythritol tetrakis(3-mercaptobutyrate), tris-[(3-mercaptopropionyloxy)-ethyl]-isocyanurate, pentaerythritol tetrakis(3-mercaptobutyrate), 1,4-bis(3-mercaptobutyryloxy)butane, 1,3,5-tris(3-mercaptobutyryloxyethyl)-1,3,5-triazine-2,4,6(1H,3H,5H)- trion, trimethylol propane tris (3-mercaptobutyrate), trimethylol ethane tris(3-mercaptobutyrate), and the like.

Examples of commercially available products of Component (B) include, but are not limited to, trimethylolpropane tris(3-mercaptopropionate) (trade name: TMMP; available from SC Organic Chemical Co., Ltd.), tris[(3-mercaptopropionyloxy)-ethyl]-isocyanurate (trade name: TEMPIC; available from SC Organic Chemical Co., Ltd.), pentaerythritol tetrakis(3-mercaptopropionate) (trade name: PEMP; available from SC Organic Chemical Co., Ltd.), tetraethyleneglycol bis(3-mercaptopropionate) (trade name: EGMP-4; available from SC Organic Chemical Co., Ltd.), dipentaerythritol hexakis(3-mercaptopropionate) (trade name: DPMP; available from SC Organic Chemical Co., Ltd.), pentaerythritol tetrakis(3-mercaptobutyrate) (trade name: Karenz MT^{®} PE1; available from Showa Denko K.K.), 1,3,5-tris(3-mercaptobutyryloxyethyl)-1,3,5-triazine-2,4,6(1H,3H,5H)-trione (trade name: Karenz MT^{®} NR1; available from Showa Denko K.K.), trimethylolpropane tris(3-mercaptobutyrate) (trade name: Karenz MT^{®} TPMB; available from Showa Denko K.K.), and the like.

In addition, an example of the (B) polythiol compound may also include a glycoluril compound represented by the following general formula (1):

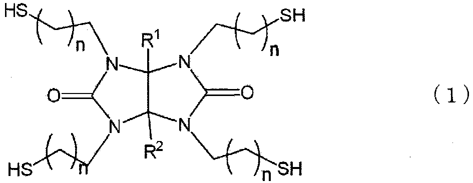

In general formula (1), R¹ and R² are each independently hydrogen or an alkyl group having 1 to 10 carbon atoms, or a phenyl group, and n is an integer of 0 to 10.

Component (B) may also be a compound represented by the following chemical formula (2) or (3).

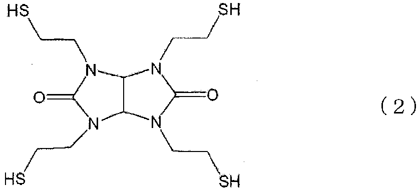

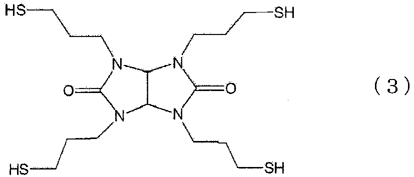

Compounds represented by chemical formula (2) and chemical formula (3), respectively, are more preferred compounds as Component (B).

Furthermore, an example of the (B) polythiol compound may also include a polythiol compound represented by general formula (4):

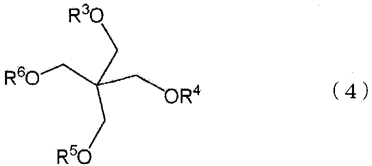

In general formula (4), R³, R⁴, R⁵ and R⁶ are each independently hydrogen or CₙH₂ₙSH (wherein n is 2 to 6), and at least one of R³, R⁴, R⁵ and R⁶ is CₙH₂ₙSH (wherein n is 2 to 6). n of the polyfunctional thiol compound represented by general formula (4) for Component (B) is preferably 2 to 4 from the viewpoint of curability. The polythiol compound is more preferably a compound having a mercaptopropyl group where n is 3 from the viewpoint of balance between physical properties of the cured products and curing speed. Component (B) represented by general formula (4) is effective when the elastic modulus of the cured product needs to be lowered, since it itself has a sufficiently flexible backbone. By adding Component (B) represented by general formula (4), the elastic modulus of the cured product can be controlled, and the adhesive strength (especially peel strength) after curing can be increased.

Examples of commercially available products for Component (B) include, but are not limited to, thiol glycoluril derivatives available from Shikoku Chemicals Corporation (trade name: TS-G (corresponding to formula (2), thiol equivalent weight: 100 g/eq) and trade name: C3 TS-G (corresponding to formula (3), thiol equivalent weight: 114 g/eq)), and a thiol compound available from SC Organic Chemical Co., Ltd. (trade name: PEPT (corresponding to formula (4), thiol equivalent weight: 124 g/eq)).

Other examples of Component (B) may include, but are not limited to, 1,3,4,6-tetrakis(mercaptomethyl)glycoluril, 1,3,4,6-tetrakis(mercaptomethyl)-3a-methylglycoluril, 1,3,4,6-tetrakis(2-mercaptoethyl)-3a-methylglycoluril, 1,3,4,6-tetrakis(3-mercaptopropyl)-3a-methylglycoluril, 1,3,4,6-tetrakis(mercaptomethyl)-3a, 6a-dimethylglycoluril, 1,3,4,6-tetrakis(2-mercaptoethyl)-3a,6a-dimethylglycoluril, 1,3,4,6-tetrakis(3-mercaptopropyl)-3a,6a-dimethylglycoluril, 1,3,4,6-tetrakis(mercaptomethyl)-3a,6a-diphenylglycoluril, 1,3,4,6-tetrakis(2-mercaptoethyl)-3a,6a-diphenylglycoluril, 1,3,4,6-tetrakis(3-mercaptopropyl)-3a,6a-diphenylglycoluril, pentaerythritol tetrapropanethiol, 1,2,3-tris(mercaptomethylthio)propane, 1,2,3-tris(2-mercaptoethylthio)propane, 1,2,3-tris(3-mercaptopropylthio)propane, 4-mercaptomethyl-1,8-dimercapto-3,6-dithiaoctane, 5,7-dimercaptomethyl-1,11-dimercapto-3,6,9-trithiaundecane, 4,7-dimercaptomethyl-1,11-dimercapto-3,6,9-trithiaundecane, 4,8-dimercaptomethyl-1,11-dimercapto-3,6,9-trithiaundecane, tetrakis(mercaptomethylthiomethyl)methane, tetrakis(2-mercaptoethylthiomethyl)methane, tetrakis(3-mercaptopropylthiomethyl)methane, 1,1,3,3-tetrakis(mercaptomethylthio)propane, 1,1,2,2-tetrakis(mercaptomethylthio)ethane, 1,1,5,5-tetrakis(mercaptomethylthio)-3-thiapentane, 1,1,6,6-tetrakis(mercaptomethylthio)-3,4-dithiahexane, 2,2-bis(mercaptomethylthio)ethanethiol, 3-mercaptomethylthio-1,7-dimercapto-2,6-dithiaheptane, 3,6-bis(mercaptomethylthio)-1,9-dimercapto-2,5,8-trithianonane, 3-mercaptomethylthio-1,6-dimercapto-2,5-dithiahexane, 1,1,9,9-tetrakis(mercaptomethylthio)-5-(3,3-bis(mercaptomethylthio)-1-thiapropyl) 3,7-dithianonane, tris(2,2-bis(mercaptomethylthio)ethyl)methane, tris(4,4-bis(mercaptomethylthio)-2-thiabutyl)methane, tetrakis(2,2-bis(mercaptomethylthio)ethyl)methane, tetrakis(4,4-bis(mercaptomethylthio)-2-thiabutyl)methane, 3,5,9,11-tetrakis(mercaptomethylthio)-1,13-dimercapto-2,6,8,12-tetrathiatridecane, 3,5,9,11,15,17-hexakis(mercaptomethylthio)-1,19-dimercapto-2,6,8,12,14,18-hexathianonadecane, 9-(2,2-bis(mercaptomethylthio)ethyl)-3,5,13,15-tetrakis(mercaptomethylthio)-1,17-dimercapto-2,6,8,10,12,16-hexathiaheptadecane, 3,4,8,9-tetrakis(mercaptomethylthio)-1,11-dimercapto-2,5,7,10-tetrathiaundecane, 3,4,8,9,13,14-hexakis(mercaptomethylthio)-1,16-dimercapto-2,5,7,10,12,15-hexathiahexadecane, 8-[bis(mercaptomethylthio)methyl]-3,4,12,13-tetrakis(mercaptomethylthio)-1,15-dimercapto-2,5,7,9,11,14-hexathiapentadecane, 4,6-bis[3,5-bis(mercaptomethylthio)-7-mercapto-2,6-dithiaheptylthio]-1,3-dithiane, 4-[3,5-bis(mercaptomethylthio)-7-mercapto-2,6-dithiaheptylthio]-6-mercaptomethylthio-1,3-dithiane, 1,1-bis[4-(6-mercaptomethylthio)-1,3-dithianylthio]-1,3-bis(mercaptomethylthio)propane, 1-[4-(6-mercaptomethylthio)-1,3-dithianylthio]-3-[2,2-bis(mercaptomethylthio)ethyl]-7,9-bis(mercaptomethylthio)-2,4,6,10-tetrathiaundecane, 3-[2-(1,3-dithietanyl)]methyl-7,9-bis(mercaptomethylthio)-1,11-dimercapto-2,4,6,10-tetrathiaundecane, 9-[2-(1,3-dithietanyl)]methyl-3,5,13,15-tetrakis(mercaptomethylthio)-1,17-dimercapto-2,6,8,10,12,16-hexathiaheptadecane, 3-[2-(1,3-dithietanyl)]methyl-7,9,13,15-tetrakis(mercaptomethylthio)-1,17-dimercapto-2,4,6,10,12,16-hexathiaheptadecane, 4,6-bis[4-(6-mercaptomethylthio)-1,3-dithianylthio]-6-[4-(6-mercaptomethylthio)-1,3-dithianylthio]-1,3-dithiane, 4-[3,4,8,9-tetrakis(mercaptomethylthio)-11-mercapto-2,5,7,10-tetrathiaundecyl]-5-mercaptomethylthio-1,3-dithiolane, 4,5-bis[3,4-bis(mercaptomethylthio)-6-mercapto-2,5-dithiahexylthio]-1,3-dithiolane, 4-[3,4-bis(mercaptomethylthio)-6-mercapto-2,5-dithiahexylthio]-5-mercaptomethylthio-1,3-dithiolane, 4-[3-bis(mercaptomethylthio)methyl-5,6-bis(mercaptomethylthio)-8-mercapto-2,4,7-trithiaoctyl]-5-mercaptomethylthio-1,3-dithiolane, 2-{bis[3,4-bis(mercaptomethylthio)-6-mercapto-2,5-dithiahexylthio]methyl}-1,3-dithietane, 2-[3,4-bis(mercaptomethylthio)-6-mercapto-2,5-dithiahexylthio]mercaptomethylthiomethyl-1,3-dithietane, 2-[3,4,8,9-tetrakis(mercaptomethylthio)-11-mercapto-2,5,7,10-tetrathiaundecylthio]mercaptomethylthiomethyl-1,3-dithietane, 2-[3-bis(mercaptomethylthio)methyl-5,6-bis(mercaptomethylthio)-8-mercapto-2,4,7-trithiaoctyl]mercaptomethylthiomethyl-1,3-dithietane, 4-{1-[2-(1,3-dithietanyl)]-3-mercapto-2-thiapropylthio}-5-[1,2-bis(mercaptomethylthio)-4-mercapto-3-thiabutylthio]-1,3-dithiolane, and the like.

Any one of them may be used alone, or two or more may be used in combination for Component (B).

As used herein, a functional group equivalent weight such as thiol equivalent weight and (meth)acryloyl equivalent weight refers to the molecular weight of the compound per functional group. The equivalent number of functional group, such as equivalent number of thiol group and equivalent number of (meth)acryloyl group, represents the number (equivalent number) of functional groups per weight (charged amount) of the compound.

In the resin composition, a ratio of an equivalent number of the (meth)acryloyl group of Component (A) to an equivalent number of the thiol group of Component (B) ([an equivalent number of the (meth)acryloyl group of Component (A)]/[an equivalent number of the thiol group of Component (B)]) is preferably 0.25 to 3.0, more preferably 0.4 to 2.0, and even more preferably 0.5 to 1.5. The thiol equivalent weight of Component (B) is theoretically the number obtained by dividing the molecular weight of Component (B) by the number of thiol groups in one molecule. The actual thiol equivalent weight can be determined, for example, by determining the thiol value by potentiometry. This method is widely known and is disclosed, for example, in paragraph 0079 of JP 2012-153794 A. The equivalent number of thiol group of Component (B) is the number of thiol groups (equivalent number) per weight (charged amount) of Component (B), and it is the quotient of the weight (g) of the thiol compound as Component (B) divided by the thiol equivalent weight of that thiol compound (the sum of such quotients for each thiol compound, if more than one thiol compound is included.). The (meth)acryloyl equivalent weight of (A) (meth)acrylate compound is theoretically equal to the number obtained by dividing the molecular weight of the (meth)acrylate compound by the number of acryloyl groups (or methacryloyl groups) in one molecule. The actual (meth)acryloyl equivalent weight of (A) (meth)acrylate compound can be measured, for example, by NMR. The equivalent number of (meth)acryloyl group of Component (A) is the number of (meth)acryloyl groups (equivalent number) per weight (charged amount) of Component (A), and it is the quotient of the weight (g) of the (meth)acrylate compound as Component (A) divided by the (meth)acryloyl equivalent weight of that (meth)acrylate compound (the sum of such quotients for each (meth)acrylate compound, if more than one (meth)acrylate compound is included.). The ratio [an equivalent number of the (meth)acryloyl group of Component (A)]/[an equivalent number of the thiol group of Component (B)] is set in the range of 0.25 to 3.0, which allows the (meth)acryloyl groups and thiol groups to react over a certain amount, so that molecular cross-links are sufficiently formed and high adhesive strength can be easily developed.

### (C) Curing catalyst

The resin composition of this aspect contains (C) a curing catalyst (hereinafter also referred to as "Component (C)"). The (C) curing catalyst used in this aspect is not particularly limited so long as it is a curing catalyst for (meth)acrylate compounds, and any known catalyst can be used. Component (C) is preferably a latent curing catalyst. A latent curing catalyst as Component (C) is a compound that is inactive at room temperature and is activated by heating to function as a curing catalyst. Examples of the latent curing catalyst include imidazole compounds that are solid at room temperature; solid dispersion type amine adduct latent curing catalysts such as reaction products of amine compounds and epoxy compounds (amine-epoxy adduct type latent curing catalysts); reaction products of amine compounds and isocyanate compounds or urea compounds (urea type adduct type latent curing catalysts).

Examples of the imidazole compounds that are solid at room temperature include, but are not limited to, 2-heptadecylimidazole, 2-phenyl-4,5-dihydroxymethylimidazole, 2-undecylimidazole, 2-phenyl-4-methyl-5-hydroxymethylimidazole, 2-phenyl-4-benzyl-5-hydroxymethylimidazole, 2,4-diamino-6-(2-methylimidazolyl-(1))-ethyl-S-triazine, 2,4-diamino-6-(2'-methylimidazolyl-(1)')-ethyl-S-triazine-isocyanuric acid adduct, 2-methylimidazole, 2-phenylimidazole, 2-phenyl-4-methylimidazole, 1-cyanoethyl-2-phenylimidazole, 1-cyanoethyl-2-methylimidazole-trimellitate, 1-cyanoethyl-2-phenylimidazole-trimellitate, N-(2-methylimidazolyl-1-ethyl)-urea, N,N'-(2-methylimidazolyl-(1)-ethyl)-azivoyldiamide, and the like.

Examples of the epoxy compounds used as one of the raw materials for making solid dispersion type amine adduct latent curing catalysts (amine-epoxy adduct type latent curing catalysts) include, but are not limited to, polyvalent phenols such as bisphenol A, bisphenol F, catechol and resorcinol, or polyglycidyl ether obtained by reacting polyhydric alcohols such as glycerin or polyethylene glycol with epichlorohydrin; glycidyl ether esters obtained by reacting hydroxycarboxylic acids such as p-hydroxybenzoic acid and β-hydroxynaphthoic acid with epichlorohydrin; polyglycidyl esters obtained by reacting polycarboxylic acids such as phthalic acid and terephthalic acid with epichlorohydrin; glycidylamine compounds obtained by reacting 4,4'-diaminodiphenylmethane or m-aminophenol with epichlorohydrin; and, polyfunctional epoxy compounds such as epoxidized phenolic novolac resin, epoxidized cresol novolac resin, epoxidized polyolefin, and monofunctional epoxy compounds such as butyl glycidyl ether, phenyl glycidyl ether, glycidyl methacrylate; and the like.

Amine compounds used as another production raw material for solid-dispersion type amine adduct latent curing catalysts can be any as long as it has at least one active hydrogen in its molecule that can additionally react with epoxy groups, and at least one functional group selected from primary, secondary and tertiary amino groups in its molecule. Examples of such amine compounds include, but are not limited to, the following. Examples of such amine compounds include, but are not limited to, aliphatic amines such as diethylenetriamine, triethylenetetramine, n-propylamine, 2-hydroxyethylaminopropylamine, cyclohexylamine, 4,4'-diaminodicyclohexylmethane; aromatic amine compounds such as 4,4'-diaminodiphenylmethane and 2-methylaniline; heterocyclic compounds containing a nitrogen atom(s) such as 2-ethyl-4-methylimidazole, 2-ethyl-4-methylimidazoline, 2,4-dimethylimidazoline, piperidine and piperazine; and the like.

Among these, compounds with intramolecular tertiary amino group(s) are raw materials that provide latent curing catalysts with excellent curing accelerating ability. Examples of such compounds include, but are not limited to, amine compounds such as dimethylaminopropylamine, diethylaminopropylamine, di-n-propylaminopropylamine, dibutylaminopropylamine, dimethylaminoethylamine, diethylaminoethylamine and N-methylpiperazine, and primary or secondary amines with intramolecular tertiary amino group(s), such as 2-methylimidazole, 2-ethylimidazole, 2-ethyl-4-methylimidazole, 2-phenylimidazole and other imidazole compounds; alcohols, phenols, thiols, carboxylic acids, and hydrazides with tertiary amino group(s) in its molecule such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, 1-(2-hydroxy-3-butoxypropyl)-2-ethyl-4-methylimidazole, 1-(2-hydroxy-3-phenoxypropyl)-2-phenylimidazoline, 1-(2-hydroxy-3-butoxypropyl)-2-methylimidazoline, 2-(dimethylaminomethyl)phenol, 2,4,6-tris(dimethylaminomethyl)phenol, N-β-hydroxyethylmorpholine, 2-dimethylaminoethanethiol, 2-mercaptopyridine, 2-benzoimidazole, 2-mercaptobenzoimidazole, 2-mercaptobenzothiazole, 4-mercaptopyridine, N,N-dimethylaminobenzoic acid, N,N-dimethylglycine, nicotinic acid, isonicotinic acid, picolinic acid, N,N-dimethylglycine hydrazide, N,N-dimethylpropionic acid hydrazide, nicotinic acid hydrazide, isonicotinic acid hydrazide; and the like.

Examples of the isocyanate compounds used as yet another production raw material for the solid-dispersion type amine adduct latent curing catalysts include, but are not limited to, monofunctional isocyanate compounds such as n-butyl isocyanate, isopropyl isocyanate, phenyl isocyanate, and benzyl isocyanate; polyfunctional isocyanate compounds such as hexamethylene diisocyanate, toluene diisocyanate, 1,5-naphthalene diisocyanate, diphenylmethane-4,4'-diisocyanate, isophorone diisocyanate, xylylene diisocyanate, para-phenylene diisocyanate, 1,3,6-hexamethylene triisocyanate, and bicycloheptane triisocyanate; compounds containing a terminal isocyanate group obtained by the reaction of the above-mentioned polyfunctional isocyanate compounds with active hydrogen compounds; and the like. Examples of the compounds containing a terminal isocyanate group include, but are not limited to, addition compounds with a terminal isocyanate group obtained by the reaction of toluylene diisocyanate with trimethylolpropane, addition compounds with a terminal isocyanate group obtained by the reaction of toluylene diisocyanate with pentaerythritol, and the like.

Examples of the urea compounds include, but are not limited to, urea, thiourea, and the like.

Solid-dispersion type latent curing catalysts that can be used in this aspect are, for example, combinations of (a) two components of the amine compound and the epoxy compound as mentioned above, (b) three components of these two components and the active hydrogen compound, or (c) two or three components of the amine compound and the isocyanate compound and/or the urea compound. They can be easily prepared by taking each component, mixing them, reacting them at temperatures from room temperature to 200°C, cooling and solidifying the reaction product, and then pulverizing it, or reacting the components in a solvent such as methyl ethyl ketone, dioxane, or tetrahydrofuran, desolventing the reaction product, and then pulverizing the solid content thereof.

Typical examples of commercially available latent curing catalyst products include, but are not limited to, amine-epoxy adduct-type products (amine adducts) such as Ajicure PN-23 (trade name; Ajinomoto Fine-Techno Co., Inc.), Ajicure PN-40 (trade name; Ajinomoto Fine-Techno Co., Inc.), Ajicure PN-50 (trade name; Ajinomoto Fine-Techno Co., Inc.), Hardner X-3661S (trade name; A.C.R. (K.K.)), Hardner X-3670S (trade name; A.C.R (K.K.)), Novacure HX-3742 (trade name; Asahi Kasei Corp.), Novacure HX-3721 (trade name; Asahi Kasei Corp.), Novacure HXA3922HP (trade name; Asahi Kasei Corp.), Novacure HXA9322HP (trade name; Asahi Kasei Corp.), Novacure HXA5945HP (trade name; Asahi Kasei Corp.), Novacure HXA5911HP (trade name; Asahi Kasei Corp.), Fujicure FXR1121 (trade name; T & K TOKA Co., Ltd.), and the like; and urea adduct products such as Fujicure FXE-1000 (trade name; T & K TOKA Co., Ltd.), Fujicure FXR-1030 (trade name; T & K TOKA Co., Ltd.), and the like. Any one of them may be used alone, or two or more may be used in combination for Component (C).

The content of (C) curing catalyst is preferably 0.1 to 40% by mass, and more preferably 1 to 20% by mass relative to the total mass of the resin composition in terms of curing speed and pot life of the resin composition.

### (D) Surfactant

The resin composition of this aspect contains (E) a surfactant having two or more hydrophilic groups selected from the group consisting of a hydroxyl group and a carbonyl group in the molecule (hereinafter also simply referred to as (D) surfactant or "Component (D)"). By including (D) surfactant, it is possible to obtain resin compositions that can reduces the bleeding phenomenon.

It is believed that, when the resin composition contains a surfactant having two or more hydrophilic groups selected from the group consisting of a hydroxyl group and a carbonyl group in the molecule, the surfactant coordinates at the interface between the resin and the substrate, and the hydrophilic portion of the surfactant (especially, the hydroxyl or carbonyl group) interacts with the substrate to produce a pinning effect, thereby reducing bleeding.

The (D) surfactant is preferably a surfactant having two or more hydroxyl groups in a molecule. In one embodiment, the (D) surfactant is preferably (D1) a surfactant with a hydrophilic portion containing a cyclic structure and/or (D2) a gemini-type surfactant.

Examples of the cyclic structure in the (D1) surfactant with a hydrophilic portion containing a cyclic structure include alicyclic hydrocarbon groups such as cyclopentane and cyclohexane, or alicyclic heterocyclic groups such as tetrahydrofuran and tetrahydropyran. The cyclic structure is preferably substituted with one or more, preferably two or more, substituents selected from the group consisting of a hydroxyl group, a carbonyl group and an ester bond. The cyclic structure is attached to the hydrophobic moiety via a spacer group containing a group selected from the group consisting of a hydroxyl group, a carbonyl group, and an ester bond, or not via such a spacer. Examples of such compounds include a compound in which a cyclic structure such as tetrahydrofuran and a saturated or unsaturated fatty acid are bonded. The structure of this compound allows the molecule to contain multiple hydrophilic groups selected from the group consisting of a hydroxyl group and a carbonyl group in a compact region, resulting in stronger interaction with the substrate and more reduction of bleeding.

The (D2) gemini-type surfactant is a surfactant with multiple, typically two, surfactants with one hydrophobic chain and one hydrophilic group, so-called monomeric surfactants, linked by a spacer. In this embodiment, it is believed that the gemini-type surfactant can have two or more hydrophilic groups selected from the group consisting of a hydroxyl group and a carbonyl group in the molecule, which makes the interaction with the substrate stronger and reduces bleeding more.

Examples of the surfactant having two or more hydrophilic groups selected from the group consisting of a hydroxyl group and a carbonyl group in the molecule include a compounds represented by the following general formula (5) or (6).

A compound represented by the general formula (5): 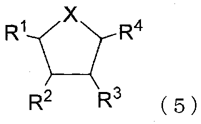
wherein in formula (5),
X is carbon (C) or oxygen (O),
R¹, R², R³ and R⁴ are each independently hydrogen (H), hydroxyl group (OH), -(CH₂)ₙ-OC(=O)-R⁵, wherein R⁵ is a fatty acid hydrocarbon chain, n is 0 to 3, (CH₂)ₙ groups may each be independently substituted with a hydroxyl group,
at least one of R¹, R², R³ and R⁴ is -(CH₂)ₙ-OC(=O)-R⁵, and
at least one of R¹, R², R³ and R⁴ is a hydroxyl group, or the hydrogen of the (CH₂)ₙ group is replaced by a hydroxyl group, so that the compound has at least one hydroxyl group.

The fatty acid hydrocarbon chain in R⁵, for example, has 10 to 20 carbons, preferably 11 to 18 carbons, and more preferably 12 to 18 carbons. The fatty acid hydrocarbon chain may contain carbon-carbon double bonds, the number of carbon-carbon double bonds being, for example, 0 to 5, preferably 0 to 3, more preferably 0 to 2. When a carbon-carbon double bond is included, both the cis and trans forms are included in the compound of formula (5).

Preferably, two of R¹, R², R³ and R⁴ are hydroxyl groups.

Preferably, the hydrogen of the (CH₂)ₙ group is replaced by at least one hydroxyl group.

Preferably, two of R¹, R², R³ and R⁴ are hydroxyl groups and the hydrogen of the (CH₂)ₙ group is replaced by at least one hydroxyl group.

Specific compounds of the general formula (5) include, for example, a compound of the following chemical formula (5a), (5b) or (5c).

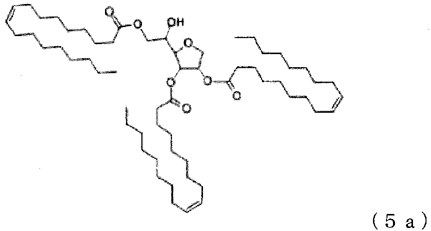

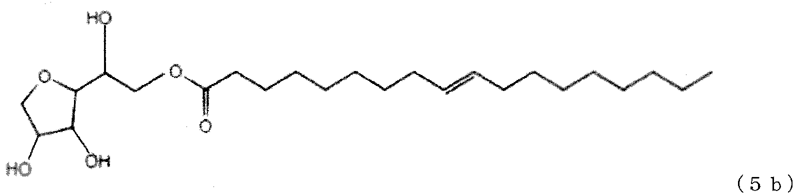

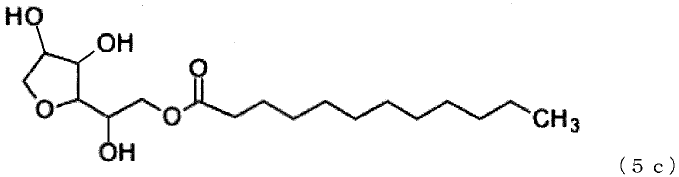

A compound represented by the general formula (6): 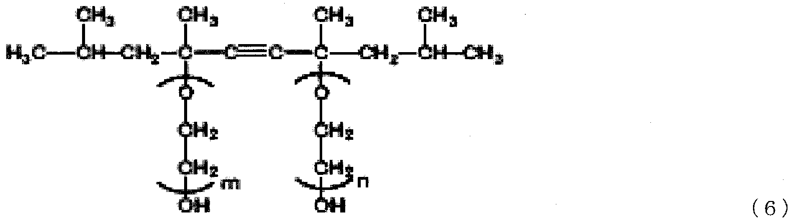 wherein in formula (6), m and n are each from 0 to 10, and m + n is from 0 to 20, preferably from 2 to 8.

Compounds of Formula (5), Formula (5a), Formula (5b), Formula (5c), and Formula (6) are not limited to the structural formula for convenience, but include all isomers that may occur in the structure of the compound (e.g., geometric isomers, chiral carbon-based optical isomers, rotational isomers, stereoisomers, and tautomers) and mixtures of two or more of these isomers.

Examples of the surfactant having two or more hydrophilic groups selected from the group consisting of a hydroxyl group and a carbonyl group in the molecule include, but are not limited to, polyoxyethylene dilaurate, polyoxyethylene dioleate, polyoxyethylene sorbitan laurate, polyoxyethylene sorbitan oleate, polyoxyethylene sorbitan trioleate, trimethylolpropane tridecanoate polyoxyalkylene butyl ether, polyoxyalkyl oleyl ether, polyoxyethylene polyoxypropylene condensate, trimethylolpropane tris, polyoxyalkylene glyceryl ether, and the like.

Any one of them may be used alone, or two or more may be used in combination for (D) surfactant.

The content of (D) surfactant is preferably 0.1 to 10% by mass, more preferably 0.2 to 7% by mass, and even more preferably 0.3 to 5% by mass relative to the total mass of the resin composition in terms of reduction of bleeding.

### (E) Zeolite particles

The resin composition of this aspect can further contain (E) zeolite particles (hereinafter also referred to as "Component (E)"). The inclusion of zeolite particles can provide additional reduction of bleeding. It is believed that, due to the high adsorptive properties of zeolite, components in the system that could become bleed are adsorbed by the zeolite, and the bleeding phenomenon is reduced more.

Zeolite is a generic term for crystalline aluminosilicate, and its general composition can be represented by the following formula (I):

Mz+[(SiO₂)x(A1₂O₃)y]z- (I)

wherein M is an ion-exchangeable cationic species, usually a monovalent or divalent metal, z is the valence of M, and x and y are arbitrary integers.

Preferably, M is a metal atom selected from groups 1 to 13, more preferably hydrogen ion (H⁺), lithium ion (Li⁺), sodium ion (Na⁺), potassium ion (K⁺), calcium ion (Ca²⁺), magnesium ion (Mg²⁺) and barium ion (Ba2⁺), and x/y (SiO₂/Al₂O₃ molar ratio) is, for example, 1 to 100, and preferably 2 to 6. The zeolite represented by formula (I) above may be further expressed as a general formula including hydrates. The SiO₂/Al₂O₃ molar ratio of zeolite can be measured using X-ray fluorescence analysis (XRF).

Zeolites have multiple crystal structures, such as A-type, X-type, LSX-type, beta-type, ZSM-5-type, ferrierite-type, mordenite-type, L-type, and Y-type. Any zeolite with any crystal structure can be used in this aspect, and type A, X, and LSX zeolites are preferred, with type A and X being more preferred, and type A being even more preferred.

In general, zeolites have cations in their crystal structure, which compensate for the lack of positive charge by compensating for the negative charge in the above crystal structure composed of aluminosilicates. Examples of cations include hydrogen, lithium, calcium, sodium, potassium, magnesium, and barium ions.

In this aspect, the zeolite is in particle form. The average particle diameter of (E) zeolite particles is preferably 1 µm or less, more preferably 10 nm to 1 µm, and even more preferably 10 nm to 500 nm from the viewpoint of more reduction of bleeding. In one embodiment, the particle diameter of (E) zeolite particles is 10 nm to 250 nm. In this embodiment, the reduction effect of bleeding is particularly pronounced. In one embodiment, the particle diameter of (E) zeolite particles is 250 nm to 1 µm. In this embodiment, both the reduction effect of bleeding and workability can be achieved.

The content of (E) zeolite particles is preferably 0.01% by mass or more, more preferably 0.05% by mass or more, and even more preferably 0.1% by mass or more relative to the total mass of the resin composition from the viewpoint of reduction of bleeding and workability of the resin composition. The content of (E) zeolite particles is also preferably 10% by mass or less, more preferably 8% by mass or less, and even more preferably 5% by mass or less. In one embodiment, the content of zeolite particles is preferably from 0.01 to 10% by mass, more preferably from 0.05 to 8% by mass, and especially preferably from 0.1 to 5% by mass.

### (F) Rubber component

The resin composition of this aspect may further contain (F) a rubber component (hereinafter also referred to as "Component (F)"). The inclusion of a rubber component can provide additional reduction of bleeding. It is believed that the rubber component acts as a steric hindrance and inhibits resin flow in the resin composition, thereby further reducing bleeding.

The type of rubber component is not limited. Preferred monomers comprising the rubber component include ethylene, propylene, butadiene, styrene, acrylonitrile, acrylic ester, methacrylic ester, urethane, epoxypropyl methacrylate, divinylbenzene, and various derivatives. The rubber component is a copolymer obtained by polymerizing a single or multiple species of these monomers. Specific examples of rubber components include acrylic rubber and urethane rubber, urethane acrylate rubber, isoprene rubber, butadiene rubber, styrene/isoprene copolymerized rubber, styrene/butadiene copolymerized rubber, acrylonitrile/butadiene copolymerized rubber, saturated rubbers in which above these diene rubbers are hydrogenated or partially hydrogenated, silicone rubber, chloroprene rubber, natural rubber, ethylene/propylene copolymer rubber, ethylene/propylene/diene monomer ternary copolymer rubber, butyl rubber, chlorosulfonated polyethylene, chlorinated polyethylene, epichlorohydrin rubber, fluoro rubber, acrylic/silicone composite rubber, and the like. Among these, from the viewpoint of reduction of bleeding, rubber components consisting of any of acrylic rubber, urethane rubber, isoprene rubber, butadiene rubber, acrylonitrile/butadiene copolymerized rubber, silicone rubber, and silicone/acrylic composite rubber are more preferred. These rubber components may be cross-linked or uncross-linked. The method of cross-linking rubber is selected according to the type of rubber component. Examples thereof include sulfur cross-linking, peroxide cross-linking, resin cross-linking, amine cross-linking, polyol cross-linking, oxime cross-linking, metal cross-linking, and the like. The (F) rubber component can be either solid at 25°C or liquid at 25°C, and both of them can be used.

When (F) rubber component is solid at 25°C, the form of (F) rubber component is not particularly limited and includes particle, powder, pellet, and the like. From the viewpoint of dispersibility, it is preferable that (F) rubber component be in particle form. The particulate rubber component may be a rubber particle having a core-shell structure, specifically, a rubber particle having the aforementioned rubber component as a core and further having a shell consisting of a polymer of a radical polymerizable compound covering the outer surface. When (F) rubber component is in particle form, the average particle diameter of (F) rubber component is preferably from 0.01 µm to 20 µm, more preferably from 0.02 µm to 10 µm, and even more preferably from 0.03 µm to 5 µm. As used herein, the average particle diameter of rubber particles is the arithmetic (number) average particle diameter, which can be measured using dynamic light scattering. The average particle diameter of rubber particles can be measured, for example, by dispersing rubber particles in a suitable organic solvent and using a particle size distribution meter.

When (F) rubber component is solid at 25°C, the glass transition point of the rubber component is preferably 40°C or less, more preferably 25°C or less, and even more preferably 0°C or less from the viewpoint of rubber elasticity. The glass transition point is preferably -100°C or higher. The glass transition point can be determined by DSC measurement based on JIS K6240.

When (F) rubber component is liquid at 25°C, the (F) rubber component is a low molecular weight component such as liquid isoprene rubber, carboxy-modified liquid isoprene rubber, liquid butadiene rubber, carboxy-modified liquid butadiene rubber, hydroxyl-modified liquid butadiene rubber, liquid acrylonitrile/butadiene copolymerized rubber, liquid styrene/butadiene copolymer rubber, liquid styrene/isoprene copolymer rubber, and liquid silicone rubber. The weight average molecular weight of the above low molecular weight component is preferably from 5,000 to 80,000, and more preferably from 8,000 to 50,000.

Commercial products of (F) rubber components which are solid at 25°C include, but are not limited to, butadiene / acrylonitrile / 2,3-epoxypropyl=methacrylate / divinylbenzene copolymer (trade name: XER81) available from JSR Corporation, and cross-linked urethane rubber beads (such as trade names: C-400T, C-600T, C-800T and C-1000T; P-400T and P-800T; U-600T; C-600TH; JB-400CB, JB-600T and JB-800T; CE-400T and CE-800T; AK-800TR; TK-800T and TK-1000TR) available from Negami Chemical Industrial Co., Ltd. Commercially available (F) rubber components which is liquid at 25°C include, but are not limited to, carboxy-terminated butadiene nitrile rubber (trade names: CTBN1300 and CTBN1008-SP) available from UBE Corporation, amine-terminated butadiene nitrile rubber (trade name: ATBN1300-16) available from UBE Corporation, silicone rubber powder (trade name: AY42-119) available from Dow TORAY, epoxidized polybutadiene rubber (trade name: EPOLEAD PB3600) available from by Daicel Corporation, and the like. Any one of them may be used alone, or two or more may be used in combination for (F) rubber component.

The content of (F) rubber component in the resin composition is preferably 0.1 to 10% by mass, more preferably 0.2 to 7% by mass, and even more preferably 0.3 to 5% by mass relative to the total mass of the resin composition.

### (G) Photo-radical initiator

The resin composition of this aspect may contain (G) a photo-radical initiator (hereinafter also referred to as "Component (G)") to the extent that the effect of the invention is not impaired. The inclusion of the (G) photo-radical initiator promotes UV curing.

Examples of the (G) photo-radical initiator may include, but are not limited to, alkylphenone compounds and acylphosphine oxide compounds.

Examples of the alkylphenone compounds may include, but are not limited to, benzyl dimethyl ketals, such as 2,2-dimethoxy-1,2-diphenylethan-1-one (commercially available as Omnirad 651 from IGM Resins B.V.); α-aminoalkylphenones such as 2-methyl-2-morpholino(4-thiomethylphenyl)propan-1-one (commercially available as Omnirad 907 from IGM Resins B.V.); α-hydroxyalkylphenones such as 1-hydroxy-cyclohexyl-phenyl-ketone (commercially available as Omnirad 184 from IGM Resins B.V.); 2-dimethylamino-2-(4-methyl-benzyl)-1-(4-morpholin-4-yl-phenyl)-butan-1-one (commercially available as Omnirad 379 EG from IGM Resins B.V.), 2-benzyl-2-(dimethylamino)-4'-morpholinobutyrophenone (commercially available as Omnirad 369 from IGM Resins B.V.), and the like.

Examples of the acylphosphine oxide compounds may include, but are not limited to, 2,4,6-trimethylbenzoyl-diphenyl phosphine oxide (commercially available as Omnirad TPO H from IGM Resins B.V.), bis(2,4,6-trimethylbenzoyl)-phenylphosphine oxide (commercially available as Omnirad 819 from IGM Resins B.V.), and the like.

In addition to the photo-radical initiators mentioned above, examples of (G) photo-radical initiator may include, but are not limited to, 2-hydroxy-2-methyl-1-phenylpropan-1-one, diethoxyacetophenone, 1-(4-isopropylphenyl)-2-hydroxy-2-methylpropan-1-one, 1-(4-dodecylphenyl)-2-hydroxy-2-methylpropan-1-one, 4-(2-hydroxyethoxy)-phenyl(2-hydroxy-2-propyl)ketone, 2-methyl-1-[4-(methylthio)phenyl]-2-morpholinopropan-1-one, benzoin, benzoin methyl ether, benzoin ethyl ether, benzoin isopropyl ether, benzoin n-butyl ether, benzoin phenyl ether, benzyl dimethyl ketal, benzophenone, benzoylbenzoate, methyl benzoylbenzoate, 4-phenylbenzophenone, hydroxybenzophenone, acrylated benzophenone, 4-benzoyl-4'-methyldiphenylsulfide, 3,3'-dimethyl-4-methoxybenzophenone, thioxansone, 2-chlorothioxansone, 2-methylthioxansone, 2,4-dimethylthioxansone, isopropylthioxansone, 2,4-dichlorothioxansone, 2,4-diethylthioxansone, 2,4-diisopropylthioxansone, 2,4,6-trimethylbenzoyl diphenylphosphine oxide, methylphenylglyoxylate, benzyl, camphorquinone, and the like.

The content of (G) photo-radical initiator is preferably 0.1 to 10 parts by mass, more preferably 0.2 to 8 parts by mass, relative to 100 parts by mass of (meth)acrylate compound from the viewpoint of UV curability.

### (H) Filler

The resin composition of this aspect may contain (H) a filler (hereinafter also referred to as "Component (H)") to the extent that the effect of the present invention is not impaired. Inclusion of the (H) filler in the resin composition lowers the linear expansion coefficient of the cured product obtained by curing the resin composition, thereby improving thermal cycle resistance. In addition, a filler with a low modulus of elasticity can relieve stresses in the cured product, improving long-term reliability. The (H) filler is broadly classified into inorganic and organic fillers.

The inorganic filler is not limited as long as it consists of a granular material formed by an inorganic material and has the effect of lowering the coefficient of linear expansion when added. However, (E) zeolite particles are excluded from (H) filler (or inorganic filler) in this description. Silica, talc, alumina, aluminum nitride, calcium carbonate, aluminum silicate, magnesium silicate, magnesium carbonate, barium sulfate, barium carbonate, lime sulfate, aluminum hydroxide, calcium silicate, potassium titanate, titanium oxide, zinc oxide, silicon carbide, silicon nitride, boron nitride, and the like can be used as the inorganic material. Any one of the inorganic fillers may be used alone, or two or more may be used in combination. Silica filler is preferred as the inorganic filler because of its high filling capacity. Amorphous silica is preferred for silica.

The inorganic filler is preferably one that has been surface treated with a coupling agent such as a silane coupling agent. This allows the viscosity of the resin composition to be within an appropriate range.

Examples of organic fillers include polytetrafluoroethylene (PTFE) filler, silicone filler, acrylic filler, styrene filler, and the like. Particulate (F) rubber components are excluded from (H) fillers (or organic fillers). Organic fillers may be surface treated. The glass transition point of the organic filler is preferably above 40°C.

The shape of the filler is not limited and can be any of spherical, phosphor, needle, irregularly shaped, and the like.

In one embodiment, the average particle diameter of the filler is preferably 5.0 µm or less, more preferably 4.0 µm or less, and even more preferably 3.0 µm or less. As used herein, the average particle diameter refers to the volume-based median diameter (d50) measured by the laser diffraction method in accordance with ISO-13320 (2009), or the value obtained as the average of 50 measurements selected from observation images obtained by transmission electron microscopy (TEM) or scanning electron microscopy (SEM). By keeping the average particle diameter of the filler below the upper limit, sedimentation of the filler can be reduced. It also reduces the formation of coarse grains, wear of the nozzle of the jet dispenser, and scattering of the resin composition ejected from the nozzle of the jet dispenser outside the desired area. The lower limit of the average particle diameter of the filler is not particularly limited, and from the viewpoint of the viscosity of the resin composition, it is preferable to be 0.005 µm or larger, and more preferable to be 0.1 µm or larger. In a certain embodiment of this aspect, the average particle diameter of the (H) filler is preferably from 0.01 µm to 5.0 µm, and more preferably from 0.1 µm to 3.0 µm. Fillers with different average particle diameters may be used in combination. For example, a filler with an average particle diameter of from 0.005 µm to less than 0.1 µm and a filler with an average particle diameter from 0.1 µm to 5.0 µm may be used in combination.

The content of (H) filler in the resin composition of this aspect is preferably 0.5 to 80% by mass, more preferably 1 to 70% by mass, and even more preferably 3 to 60% by mass relative to the total mass of the resin composition. By setting the content of (H) filler in the above range, the thermal cycle resistance is improved, and the viscosity of the resin composition is set in an appropriate range, improving its applicability for dispensing.

### (I) Stabilizer

The resin composition of this aspect may contain (I) a stabilizer (hereinafter also referred to as "Component (I)") to the extent that the effect of the invention is not impaired. (I) Stabilizer is added to increase the stability of the resin composition during storage and to reduce the occurrence of polymerization reactions caused by unintended radicals or basic components. Typically, examples of (I) stabilizer may include radical polymerization inhibitors and anionic polymerization inhibitors.

Known radical polymerization inhibitors can be used, and examples thereof may include, but are not limited to, N-nitroso-N-phenylhydroxylamine aluminum, triphenylphosphine, p-methoxyphenol, hydroquinone, and the like. Also, known radical polymerization inhibitors disclosed in JPA 2010-117545, JPA 2008-184514, etc. can be used. Any one type of radical polymerization inhibitors may be used, or two or more may be used in combination.

When a radical polymerization inhibitor is included, the content of the radical polymerization inhibitor is preferably 0.0001 to 5% by mass and more preferably 0.001 to 3% by mass relative to the total mass of the resin composition from the viewpoint of pot life.

Known anionic polymerization inhibitors can be used, and examples thereof may include boric acid ester compounds and strong acids. Specific examples of anionic polymerization inhibitors may include, but are not limited to, trimethylborate, triethylborate, tri-n-propylborate, triisopropylborate, trifluoromethanesulfonic acid, maleic acid, methanesulfonic acid, barbituric acid, difluoroacetic acid, trichloroacetic acid, phosphoric acid, dichloroacetic acid, and the like. Among these, the preferred anionic polymerization inhibitor is at least one selected from tri-n-propylborate, triisopropylborate, and barbituric acid. As anionic polymerization inhibitors, well-known ones disclosed in JPA 2010-117545, JPA 2008-184514, JPA 2017-171804, and other publications can also be used. Any one type of anionic polymerization inhibitors may be used, or two or more may be used in combination.

When an anionic polymerization inhibitor is included, the content of the anionic polymerization inhibitor is preferably 0.001 to 5% by mass and more preferably 0.01 to 3% by mass relative to the total mass of the resin composition.

The resin composition of this aspect may, if desired, further contain other additives, such as a solvent, a coupling agent, carbon black, titanium black, an ion trap agent, a leveling agent, an antioxidant, a defoaming agent, a thixotropic agent, a viscosity modifier, a flame retardant, and/or other additives.

The method of producing the resin composition of this aspect is not limited. For example, Components (A) to (D), and if necessary, Components (E), (F), (G), (H), (I), and/or other additives, and the like can be introduced simultaneously or separately into an appropriate mixing machine and subjected to stirring, melting, mixing, and dispersing while subjecting to heating if necessary, to obtain a composition as the resin composition. The equipment for mixing, stirring, and dispersing these materials is not limited. A ricer, Henschel mixer, 3-roll mill, ball mill, planetary mixer, bead mill, and the like, equipped with an agitator and heating device can be used. A combination of these devices may also be used as appropriate.

The resulting resin compositions are photo-curable and thermo-curable, and also cures sufficiently by heat curing alone. The thermal curing temperature of the resin composition is preferably 60 to 90°C when the resin composition is used in image sensor modules.

The resin compositions of this aspect can be used, for example, as adhesives, sealants, damming agents, and raw materials for fixing, bonding, or protecting parts, and are suitable as one-component types. Here, damming agents are used, for example, to form a dam around the perimeter of a substrate in advance before encapsulating multiple semiconductor chips, etc. on the substrate with a low viscosity fill agent or the like. The formation of the dam by the damming agent prevents the subsequent outflow of the low-viscosity fill agent that encapsulates multiple semiconductor chips. Adhesives containing the resin composition of this aspect also enable good bonding to engineering plastics, ceramics, and metals.

### [Adhesive or sealant]

An adhesive or a sealant, which is the second aspect of the invention, contains the resin composition of the first aspect described above. This adhesive or sealant allows good bonding to engineering plastics, ceramics, and metals. The adhesive or sealant of this aspect is preferably used for fixing, bonding or protecting the components that make up the image sensor or camera module.

### [Cured product of the resin composition or adhesive or sealant]

The cured product, which is the third aspect of the present invention, is a cured product in which the resin composition of the first aspect or the adhesive or sealant of the second aspect described above has been cured.

### [Semiconductor device and electronic component]

A semiconductor device or an electronic component, which is the fourth aspect of the present invention, contains the cured product of the third aspect described above. The term "semiconductor device" refers to all devices that can function by utilizing semiconductor characteristics and includes electronic components, semiconductor circuits, modules incorporating these components, and electronic equipment. Examples of the semiconductor device or electronic component include, but are not limited to, HDDs, semiconductor elements, sensor modules such as image sensor modules, camera modules, semiconductor modules, integrated circuits, and the like. In one embodiment, the semiconductor device or electronic component may be an image sensor or camera module.

### Examples

Hereinbelow, the present invention will be described in more detail with reference to the following Examples and Comparative Examples, which should not be construed as limiting the scope of the present invention. In the following examples, parts and percentages refer to parts by mass and percentages by mass, unless otherwise noted.

### [Examples 1 to 29, and Comparative Examples 1 to 4]

Each of resin compositions was prepared by mixing each of the components in the amounts according to the formulations shown in Table 1 using a three-roll mill. In Table 1, the amount of each component is expressed in parts by mass (unit: g). The ingredients used in Examples and Comparative Examples are as follows.
- (A) (Meth)acrylate compound (Component (A))
   (A-1): Polyester acrylate (trade name: M7100, (meth)acryloyl equivalent weight: 188 g/eq) available from TOAGOSEI CO., LTD.
   (A-2): Dimethylol tricyclodecanediacrylate (trade name: Light Acrylate DCP-A, (meth)acryloyl equivalent weight: 152 g/eq) available from Kyoeisha Chemical Co., Ltd.
   (A-3): Neopentyl glycol modified trimethylolpropanediacrylate (trade name: KAYARAD R-604, (meth)acryloyl equivalent weight: 163 g/eq) available from Nippon Kayaku Co., Ltd.
- (B) Polythiol compound (Component (B))
   (B-1): Pentaerythritol tetrakis(3-mercaptopropionate) (trade name: PEMP, thiol equivalent weight: 122 g/eq) available from SC Organic Chemical Co., Ltd.
   (B-2): Thiol glycoluril derivative (trade name: C3 TS-G, thiol equivalent weight: 114 g/eq) available from Shikoku Chemicals Corporation
- (C) Curing catalyst (Component (C))
   (C-1): Solid dispersion latent curing catalyst (trade name: Fujicure FXR1121) available from T & K TOKA Co., Ltd.
- (D) Surfactant (Component (D))
   (D-1): Sorbitan laurate (trade name: D-931) available from TAKEMOTO OIL & FAT CO., LTD.
   (D-2): Sorbitan oleate (trade name: D-935) available from TAKEMOTO OIL & FAT CO., LTD.
   (D-3): Sorbitan trioleate (trade name: D-935T) available from TAKEMOTO OIL & FAT CO., LTD.
   (D-4): Polyoxyethylene(4) acetylenic glycol ether (trade name: Acetylenol E40) available from Kawaken Fine Chemicals Co., Ltd.
   (D-5): Polyoxyethylene(6) acetylenic glycol ether (trade name: Acetylenol E60) available from Kawaken Fine Chemicals Co., Ltd.
- (D') Surfactant other than Component (D)
   (D'-1): Polyoxyethylene oleyl ether (trade name: D-1502) available from TAKEMOTO OIL & FAT CO., LTD.
- (E) Zeolite particles (Component (E))
   (E-1): Zeolite particles (trade name: Zeoal4A 300 nm) available from Nakamura Choukou Co., Ltd.
   (E-2): Zeolite particles (trade name: Zeoal4A 50 nm) available from Nakamura Choukou Co., Ltd.
- (F) Rubber (Component (F))
   (F-1):butadiene / acrylonitrile / 2,3-epoxypropyl=methacrylate / divinylbenzene copolymer (trade name: XER81) available from JSR Corporation
- (G) Photo-radical initiator (Component (G))
   (G-1): α-aminoalkylphenones; 1-hydroxy-cyclohexyl-phenyl-ketone (trade name: Omnirad 184) available from IGM Resins B.V.
- (H) Filler (Component (H))
   (H-1): Calcium carbonate (trade name: CS3NA) available from Ube Material Industries, Ltd.

### [Evaluation of bleeding]

On a ceramic substrate plasma-treated with argon (Ar) gas, 1.5 mg of each of the resin compositions of the Examples and Comparative Examples were potted by a dispenser. After potting, each resin composition was allowed to stand at room temperature for 5 minutes and then thermally cured at 80°C for 60 minutes. The length of bleed generated on the ceramic substrate in each resin composition after curing was measured with a CCD camera (N = 3pcs x 2sides). Results are shown in Table 1.

**[Table 1-1]**

| | | Example 1 | Example 2 | Example 3 | Example 4 | Example 5 | Example 6 | Example 7 | Example 8 |
|---|---|---|---|---|---|---|---|---|---|
| Component (A) | A-1 | 31.6 | 31.6 | 31.6 | 31.6 | 31.6 | 32.1 | 59.5 | 0.0 |
| | A-2 | 25.5 | 25.5 | 25.5 | 25.5 | 25.5 | 26.0 | 0.0 | 0.0 |
| | A-3 | 0.0 | 0.0 | 0.0 | 0.0 | 0.0 | 0.0 | 0.0 | 56.1 |
| Component (B) | B-1 | 41.0 | 41.0 | 41.0 | 41.0 | 41.0 | 25.3 | 38.6 | 42.0 |
| | B-2 | 0.0 | 0.0 | 0.0 | 0.0 | 0.0 | 14.8 | 0.0 | 0.0 |
| Component (C) | C-1 | 1.6 | 1.6 | 1.6 | 1.6 | 1.6 | 1.6 | 1.6 | 1.6 |
| Component (D) | D-1 | 0.3 | 0 | 0 | 0 | 0 | 0.3 | 0.3 | 0.3 |
| | D-2 | 0 | 0.3 | 0 | 0 | 0 | 0 | 0 | 0 |
| | D-3 | 0 | 0 | 0.3 | 0 | 0 | 0 | 0 | 0 |
| | D-4 | 0 | 0 | 0 | 0.3 | 0 | 0 | 0 | 0 |
| | D-5 | 0 | 0 | 0 | 0 | 0.3 | 0 | 0 | 0 |
| Component (D') | D'-1 | 0 | 0 | 0 | 0 | 0 | 0 | 0 | 0 |
| Component (E) | E-1 | 0 | 0 | 0 | 0 | 0 | 0 | 0 | 0 |
| | E-2 | 0 | 0 | 0 | 0 | 0 | 0 | 0 | 0 |
| Component (F) | F-1 | 0 | 0 | 0 | 0 | 0 | 0 | 0 | 0 |
| Component (G) | G-1 | 0 | 0 | 0 | 0 | 0 | 0 | 0 | 0 |
| Component (H) | H-1 | 0 | 0 | 0 | 0 | 0 | 0 | 0 | 0 |
| Total | | 100 | 100 | 100 | 100 | 100 | 100 | 100 | 100 |
| Bleed length (*µ*m) | | 650 | 280 | 810 | 330 | 450 | 670 | 600 | 680 |

**[Table 1-2]**

| | | Example 9 | Example 10 | Example 11 | Example 12 | Example 13 | Comparative Example 1 | Comparative Example 2 |
|---|---|---|---|---|---|---|---|---|
| Component (A) | A-1 | 31.5 | 31.5 | 31.5 | 31.5 | 31.4 | 31.7 | 31.5 |
| | A-2 | 25.5 | 25.5 | 25.5 | 25.5 | 25.4 | 25.6 | 25.5 |
| | A-3 | 0.0 | 0.0 | 0.0 | 0.0 | 0.0 | 0.0 | 0.0 |
| Component (B) | B-1 | 40.9 | 40.9 | 40.9 | 40.9 | 40.7 | 41.1 | 40.9 |
| | B-2 | 0.0 | 0.0 | 0.0 | 0.0 | 0.0 | 0.0 | 0.0 |
| Component (C) | C-1 | 1.6 | 1.6 | 1.6 | 1.6 | 1.6 | 1.6 | 1.6 |
| Component (D) | D-1 | 0.3 | 0.3 | 0.3 | 0 | 0.3 | 0 | 0 |
| | D-2 | 0 | 0 | 0 | 0.3 | 0 | 0 | 0 |
| | D-3 | 0 | 0 | 0 | 0 | 0 | 0 | 0 |
| | D-4 | 0 | 0 | 0 | 0 | 0 | 0 | 0 |
| | D-5 | 0 | 0 | 0 | 0 | 0 | 0 | 0 |
| Component (D') | D'-1 | 0 | 0 | 0 | 0 | 0 | 0 | 0.3 |
| Component (E) | E-1 | 0.3 | 0 | 0 | 0 | 0.3 | 0 | 0.3 |
| | E-2 | 0 | 0.3 | 0 | 0 | 0 | 0 | 0 |
| Component (F) | F-1 | 0 | 0 | 0.3 | 0.3 | 0.3 | 0 | 0 |
| Component (G) | G-1 | 0 | 0 | 0 | 0 | 0 | 0 | 0 |
| Component (H) | H-1 | 0 | 0 | 0 | 0 | 0 | 0 | 0 |
| Total | | 100 | 100 | 100 | 100 | 100 | 100 | 100 |
| Bleed length (*µ*m) | | 350 | 60 | 300 | 200 | 10 | 1890 | 1900 |

**[Table 1-3]**

| | | Example 14 | Example 15 | Example 16 | Example 17 | Example 18 | Example 19 | Example 20 | Example 21 | Comparative Example 3 |
|---|---|---|---|---|---|---|---|---|---|---|
| Component (A) | A-1 | 30.9 | 30.9 | 30.9 | 30.9 | 30.9 | 30.8 | 30.8 | 30.8 | 31.0 |
| | A-2 | 25.0 | 25.0 | 25.0 | 25.0 | 25.0 | 24.9 | 24.9 | 24.9 | 25.1 |
| | A-3 | 0.0 | 0.0 | 0.0 | 0.0 | 0.0 | 0.0 | 0.0 | 0.0 | 0.0 |
| Component (B) | B-1 | 40.2 | 40.2 | 40.2 | 40.2 | 40.2 | 40.0 | 40.0 | 40.0 | 40.3 |
| | B-2 | 0.0 | 0.0 | 0.0 | 0.0 | 0.0 | 0.0 | 0.0 | 0.0 | 0.0 |
| Component (C) | C-1 | 1.6 | 1.6 | 1.6 | 1.6 | 1.6 | 1.6 | 1.6 | 1.6 | 1.6 |
| Component (D) | D-1 | 0.3 | 0 | 0 | 0 | 0 | 0.3 | 0.3 | 0.3 | 0 |
| | D-2 | 0 | 0.3 | 0 | 0 | 0 | 0 | 0 | 0 | 0 |
| | D-3 | 0 | 0 | 0.3 | 0 | 0 | 0 | 0 | 0 | 0 |
| | D-4 | 0 | 0 | 0 | 0.3 | 0 | 0 | 0 | 0 | 0 |
| | D-5 | 0 | 0 | 0 | 0 | 0.3 | 0 | 0 | 0 | 0 |
| Component (D') | D'-1 | 0 | 0 | 0 | 0 | 0 | 0 | 0 | 0 | 0 |
| Component (E) | E-1 | 0 | 0 | 0 | 0 | 0 | 0.3 | 0 | 0 | 0 |
| | E-2 | 0 | 0 | 0 | 0 | 0 | 0 | 0 | 0 | 0 |
| Component (F) | F-1 | 0 | 0 | 0 | 0 | 0 | 0 | 0.3 | 0.3 | 0 |
| Component (G) | G-1 | 2 | 2 | 2 | 2 | 2 | 2 | 2 | 2 | 2 |
| Component (H) | H-1 | 0 | 0 | 0 | 0 | 0 | 0 | 0 | 0 | 0 |
| Total | | 100 | 100 | 100 | 100 | 100 | 100 | 100 | 100 | 100 |
| Bleed length (*µ*m) | | 620 | 300 | 800 | 350 | 450 | 400 | 380 | 40 | 1830 |

**[Table 1-4]**

| | | Example 22 | Example 23 | Example 24 | Example 25 | Example 26 | Example 27 | Example 28 | Example 29 | Comparative Example 4 |
|---|---|---|---|---|---|---|---|---|---|---|
| Component (A) | A-1 | 28.4 | 28.4 | 28.4 | 28.4 | 28.4 | 28.3 | 28.3 | 28.3 | 28.5 |
| | A-2 | 22.9 | 22.9 | 22.9 | 22.9 | 22.9 | 22.9 | 22.9 | 22.9 | 23.0 |
| | A-3 | 0.0 | 0.0 | 0.0 | 0.0 | 0.0 | 0.0 | 0.0 | 0.0 | 0.0 |
| Component (B) | B-1 | 36.8 | 36.8 | 36.8 | 36.8 | 36.8 | 36.7 | 36.7 | 36.7 | 36.9 |
| | B-2 | 0.0 | 0.0 | 0.0 | 0.0 | 0.0 | 0.0 | 0.0 | 0.0 | 0.0 |
| Component (C) | C-1 | 1.6 | 1.6 | 1.6 | 1.6 | 1.6 | 1.6 | 1.6 | 1.6 | 1.6 |
| Component (D) | D-1 | 0.3 | 0 | 0 | 0 | 0 | 0.3 | 0.3 | 0.3 | 0 |
| | D-2 | 0 | 0.3 | 0 | 0 | 0 | 0 | 0 | 0 | 0 |
| | D-3 | 0 | 0 | 0.3 | 0 | 0 | 0 | 0 | 0 | 0 |
| | D-4 | 0 | 0 | 0 | 0.3 | 0 | 0 | 0 | 0 | 0 |
| | D-5 | 0 | 0 | 0 | 0 | 0.3 | 0 | 0 | 0 | 0 |
| Component (D') | D'-1 | 0 | 0 | 0 | 0 | 0 | 0 | 0 | 0 | 0 |
| Component (E) | E-1 | 0 | 0 | 0 | 0 | 0 | 0.3 | 0 | 0 | 0 |
| | E-2 | 0 | 0 | 0 | 0 | 0 | 0 | 0 | 0 | 0 |
| Component (F) | F-1 | 0 | 0 | 0 | 0 | 0 | 0 | 0.3 | 0.3 | 0 |
| Component (G) | G-1 | 0 | 0 | 0 | 0 | 0 | 0 | 0 | 0 | 0 |
| Component (H) | H-1 | 10 | 10 | 10 | 10 | 10 | 10 | 10 | 10 | 10 |
| Total | | 100 | 100 | 100 | 100 | 100 | 100 | 100 | 100 | 100 |
| Bleed length (*µ*m) | | 260 | 200 | 430 | 180 | 240 | 160 | 130 | 40 | 980 |

It can be seen that the bleeding phenomenon was significantly reduced in the resin compositions of Examples 1 to 5, by containing (D) surfactant corresponding to the present invention, as compared to the resin composition of Comparative Example 1, which does not contain (D) surfactant, and the resin composition of Comparative Example 2, which contains (D') surfactant not corresponding to the present invention instead of (D) surfactant corresponding to the present invention.

It can be seen that the bleeding phenomenon was significantly reduced in the resin compositions of Examples 6 to 8, in which the type and amount of (A) (meth)acrylate compound and (B) polythiol compound were varied, by containing (D) surfactant corresponding to the present invention, as compared to the resin composition of Example 1, which does not contain (D) surfactant.

It can be seen that the bleeding phenomenon was further significantly reduced in the resin compositions of Examples 9 to 13, by containing (D) surfactant corresponding to the present invention and at least one of (E) zeolite particles and (F) rubber component.

When considering Examples 14 to 21 and Comparative Example 3, all of which contain (G) photo-radical initiator, the bleeding phenomenon was significantly reduced in the resin compositions of Examples 14 to 21 by containing (D) surfactant corresponding to the present invention as compared to the resin composition of Comparative Example 3, which does not contain (D) surfactant.

When considering Examples 22 to 29 and Comparative Example 4, all of which contain (H) filler, the bleeding phenomenon was significantly reduced in the resin compositions of Examples 22 to 29 by containing (D) surfactant corresponding to the present invention as compared to the resin composition of Comparative Example 4, which does not contain (D) surfactant.

### Industrial applicability

The present invention is at least thermo-curable resin compositions and adhesives capable of reducing the bleeding phenomenon, and is very useful, especially as an adhesive or sealant for fixing, bonding, or protecting components in miniaturized or highly integrated semiconductor modules.

The disclosure of Japanese Patent Application No. 2022-048208 (filing date: March 24, 2022) is incorporated herein by reference in its entirety.

All references, patent applications, and technical standards described herein are incorporated herein by reference to the same extent as if the individual references, patent applications, and technical standards were specifically and individually noted as being incorporated by reference.

## Claims

1. A resin composition comprising:
(A) a (meth)acrylate compound,
(B) a polythiol compound,
(C) a curing catalyst, and
(D) a surfactant having two or more hydrophilic groups selected from the group consisting of a hydroxyl group and a carbonyl group in the molecule.

2. The resin composition according to claim 1, wherein the (D) surfactant is a surfactant having two or more hydroxyl groups in the molecule.

3. The resin composition according to claim 1 or 2, wherein the (D) surfactant is (D1) a surfactant with a hydrophilic portion containing a cyclic structure and/or (D2) a gemini-type surfactant.

4. The resin composition according to any one of claims 1 to 3, further comprising (G) a photo-radical initiator.

5. An adhesive or a sealant comprising the resin composition according to any one of claims 1 to 4.

6. The adhesive or sealant according to claim 5, for use in the fixation, adhesion or protection of components of an image sensor or a camera module.

7. A cured product in which the resin composition according to any one of claims 1 to 4 or the adhesive or sealant according to claim 5 or 6 has been cured.

8. A semiconductor device or an electronic component comprising the cured product according to claim 7.

9. The semiconductor device or the electronic component according to claim 8, which is an image sensor or a camera module.
